# FASCICULE DE BREVET EUROPEEN

(11) **EP 3 381 060 B1**
(45) Date de publication et mention de la délivrance du brevet: **23.10.2019**
(21) Numéro de dépôt: 16809992.7
(22) Date de dépôt: 15.11.2016
(51) Int. Cl.: H01L 25/075, H01L 25/16, H01L 33/00, H01L 33/38

(54) **PROCÉDÉ DE FABRICATION D'UNE DALLE LUMINEUSE**
VERFAHREN ZUR HERSTELLUNG EINER BELEUCHTETEN FRONTPLATTE
METHOD FOR PRODUCING AN ILLUMINATED FACEPLATE

(30) Priorité: 26.11.2015 FR 1561421
(43) Date de publication de la demande: 03.10.2018
(73) Titulaire: Commissariat à l'Énergie Atomique et aux Énergies Alternatives, 75015 Paris (FR)
(72) Inventeur: ROBIN, Ivan-Christophe, 38000 Grenoble (FR); MOUREY, Bruno, 38500 Coublevie (FR)
(74) Mandataire: Cabinet Laurent & Charras
(86) Numéro de dépôt international: PCT/FR2016/052957
(87) Numéro de publication internationale: WO 2017/089676

(56) Documents cités:
- WO-A1-2008/109296
- WO-A1-2012/156121
- WO-A1-2014/184488
- CN-A- 104 282 678
- DE-A1-102012 112 302
- US-A1- 2010 267 176
- US-A1- 2014 120 640
- US-A1- 2014 191 246

## Description

### DOMAINE DE L'INVENTION

L'invention a trait aux dalles lumineuses, en particulier celles d'écrans, e.g. d'ordinateurs, de smartphones, de télévision, de tablettes, ou de projecteurs d'images.

L'invention concerne plus particulièrement les dalles lumineuses à base de micro-diodes électroluminescences (« *micro-LEDs* ») inorganiques, en particulier de micro-LEDs à base de nitrure de gallium (« *GaN* ») ou de matériaux dérivés.

### ETAT DE LA TECHNIQUE

De manière schématique, une dalle lumineuse comporte une matrice d'éléments lumineux, ou pixels, commandés individuellement par une matrice de circuits de commande (ou « *matrice active* »). Chaque circuit de commande comprend, pour le pilotage de son pixel associé, un ou plusieurs transistors, fonctionnant en tant qu'interrupteur(s), et le plus souvent un condensateur de maintien de la polarisation du pixel entre deux rafraichissement de l'affichage de la dalle.

A ce jour, seules deux technologies permettent la réalisation de dalles lumineuses de grandes dimensions et de longue durée de vie, à savoir la technologie à base de cristaux liquides (écran « *LCD* »), et la technologie à base de plasma (écran « *plasma* »). Chacune de ces technologies présente cependant de nombreux désavantages, par exemple, un problème de rendement énergétique et de directivité pour les écrans LCD, et un problème de consommation et de brûlure d'écran pour les écrans plasma.

Des technologies alternatives, notamment à base de photo-diodes organiques (ou *« OLED* »), ont ainsi été développées, sans pour autant donner un résultat satisfaisant. En effet, les écrans à base d'OLED présentent des problèmes de brillance et ont une durée de vie trop courte, limitant leur utilisation à des dispositifs jugés à courte vie (smartphone notamment).

Parallèlement, quelles que soient les technologies envisagées pour la production de lumière (LCD, plasma, OLED, ...), les circuits de commande sont fabriqués en technologie de dépôt en couches minces, dite « *TFT »* (acronyme anglo-saxon de « *thin film transistor* »). Les composants électroniques des circuits de commande (transistor(s), condensateur, pistes électriques notamment) sont ainsi réalisés en déposant successivement des couches minces de matériau et en utilisant des masques de photolithographie pour délimiter leurs éléments constitutifs (électrodes, couche semi-conductrice, couche diélectrique, pistes...). Par exemple, la fabrication des circuits de commande d'un écran LCD, comprenant chacun seulement un transistor et un condensateur, nécessite l'emploi de 5 à 9 masques de photolithographie. Le prix de revient des circuits de commande fabriqués selon cette technologie est donc très élevé. En outre, la fabrication d'une matrice active de grande dimension selon la technologie TFT classique renchérit sensiblement le prix d'un écran en raison du coût des équipements permettant de déposer des couches minces sur de grandes surfaces. C'est pourquoi on estime que seuls quelques acteurs du marché, capables d'investir dans des équipements très onéreux, sont susceptibles aujourd'hui d'en supporter le coût.

Chacun des documents US 2014/191246 A1 et WO 2008/109296 A1 se rapporte à une dalle lumineuse comportant des micro-LEDs solidarisées à des puces de commande à base de transistors.

### EXPOSE DE L'INVENTION

Le but de la présente invention est de proposer un procédé de fabrication d'une dalle lumineuse, basée sur une technologie d'émission de lumière autre que les technologies LCD, plasma et OLED, capable de réaliser une dalle lumineuse à un cout réduit.

A cet effet, l'invention a pour objet un procédé de fabrication d'une dalle lumineuse, comprenant :
- la fabrication d'un premier substrat comportant :
   ∘ un empilement de couches semi-conductrices constitutives de micro-LEDs semi-conductrices inorganiques ; et
   ∘ une matrice de connexions électriques pour les micro-LEDs,
      la fabrication du premier substrat étant réalisée de telle sorte que les connexions électriques sont disposées sur une première face du premier substrat;
- la fabrication dans un second substrat en silicium, indépendamment du premier substrat, d'une matrice de circuits de commande des micro-LEDs à base de transistor, ladite fabrication étant réalisée de telle sorte que :
   ∘ des premières connexions pour la commande des micro-LEDs sont disposées sur une première face du second substrat ;
   ∘ et des secondes connexions pour le pilotage de la dalle lumineuse sont disposées sur une seconde face du second substrat;
- le report des premières faces du premier substrat et du second substrat l'une sur l'autre et la solidarisation desdites faces, de sorte à connecter électriquement les connexions électriques des micro-LEDs avec les premières connexions électriques des circuits de commande, obtenant ainsi un troisième substrat comprenant une matrice de micro-puces électroniques, constituée chacune de l'empilement d'une micro-LED et d'un circuit de commande ;
- la fabrication d'une structure de transfert des micro-puces comprenant :
   ∘ un substrat de transfert;
   ∘ et la matrice de micro-puces, chaque micro-puce étant solidarisée au substrat de transfert uniquement par sa micro-LED, et individualisée par la réalisation d'une tranchée dans le troisième substrat autour de la micro-puce ;
- la fabrication d'un quatrième substrat, indépendamment de la structure de transfert, comportant des connexions électriques d'amenée de signaux pour le pilotage de la dalle lumineuse, lesdites connexions étant disposées sur une première face du quatrième substrat ; et
- le report de la structure de transfert sur la première face du quatrième substrat, la solidarisation des micro-puces avec la première face du quatrième substrat de sorte à connecter les secondes connexions des circuits de commande avec les connexions électriques du quatrième substrat, et la désolidarisation des micro-puces du substrat de transfert.

En d'autres termes, la dalle lumineuse ainsi fabriquée comprend une matrice de micro-LEDs inorganiques, et donc à durée de vie plus longue que les OLEDs. Chaque micro-LED comprend une face libre de tout composant électronique ou électrique, à la différence des dalles LCD, dont le cristal liquide est partiellement masqué par la matrice active, et à la différence des dalles plasma dont les cellules à plasma sont masquées partiellement par des électrodes. Ceci explique notamment l'emploi de la technologie TFT pour les dalles LCD et plasma puisque qu'elle permet la fabrication de matrices actives ou d'électrodes de très faible épaisseur, et donc peu perturbatrices.

Grâce à l'agencement des micro-LEDS selon l'invention, il est possible de se passer de cette technologie onéreuse. La matrice active de l'invention est donc avantageusement réalisée selon une technique classique de la micro-électronique, par exemple celle bien connue des circuits ASICs pour lesquels les transistors sont réalisées directement dans le volume (ou « *bulk* ») d'une tranche de silicium (ou « *wafer* »), et non pas par dépôts successifs de couches de matériaux. Ainsi, il est possible de réaliser des dalles lumineuses dont les dimensions sont au moins égales à celles de wafers usuels du domaine de la fabrication de puces électroniques (e.g. wafer pour la fabrication de circuits ASICs), voire réaliser la dalle à partir de plusieurs wafers. L'invention permet en outre de réaliser, dans la matrice active, tout type de schéma électronique pour la commande des micro-LEDs. Notamment, la matrice active de l'invention peut être réalisée selon un schéma de l'état de la technique, chaque micro-LED étant par conséquent commandée de la même manière que dans l'état de la technique avec des transistors individuels de commande, des condensateurs, etc. Les avantages liés à ce type de commande (réactivité, qualité d'affichage, etc.) sont donc conservés. A la différence toutefois de la couteuse technologie TFT qui fabrique des transistors déjà interconnectés, les transistors de la matrice active de l'invention sont interconnectés après leur fabrication, après report, par des pistes conductrices d'une matrice passive.

En outre, l'invention met en œuvre le report de substrats les uns sur les autres. Or, les reports de substrats sont réalisables par des machines conventionnelles du domaine de la micro-électronique.

Au final, il est donc obtenu une dalle lumineuse en technologie micro-LED inorganiques de faible coût, et de grande surface si besoin.

Selon un mode de réalisation, la fabrication de la structure de transfert des micro-puces comporte :
- le report et le collage temporaire du troisième substrat sur le substrat de transfert ;
- suivi de la formation des tranchées autours des micro-puces jusqu'au substrat de transfert.

En d'autres termes, l'invention fait avantageusement usage des reports à l'aide de substrat poignée.

En variante :
- la fabrication du premier substrat comporte la fabrication d'un substrat de croissance et la croissance par épitaxie des couches semi-conductrices constitutives des micro-LEDs, le substrat de croissance formant le substrat de la structure de transfert des micro-puces ;
- la fabrication de la structure de transfert des micro-puces comporte la formation de tranchées autour des micro-puces jusqu'au substrat de transfert ;
- la désolidarisation des micro-puces du substrat de transfert comporte l'irradiation laser du substrat de transfert au droit des micro-puces de manière à obtenir le détachement de celles-ci du substrat de transfert.

Dans cette variante, le substrat de croissance joue donc la fonction de substrat poignée, économisant ainsi une étape de fabrication/report.

Selon un mode de réalisation :
- la matrice de micro-puces de la structure de transfert présente un premier pas de répétition ;
- les connexions électriques du quatrième substrat sont agencées en matrice avec un second pas de répétition supérieur au premier pas de répétition ;
- le report de la structure de transfert, la solidarisation des micro-puces avec la première face du quatrième substrat, et la désolidarisation des micro-puces du substrat de transfert, comprennent :
   ∘ le report de la structure de transfert sur une première position du quatrième substrat;
   ∘ la solidarisation d'au moins une première micro-puce sur la première position ;
   ∘ le report de la structure de transfert sur une seconde position du quatrième substrat en décalant la structure de transfert et le quatrième substrat l'un par rapport à l'autre du second pas de répétition ;
   ∘ et la solidarisation d'au moins une seconde micro-puce à la seconde position.

En d'autres termes, le procédé permet de fabriquer les micro-puces avec une densité élevée, indépendamment du pas final souhaité pour la dalle lumineuse, augmentant de fait le rendement de fabrication. Les micro-puces sont ensuite reportées au pas de pixels souhaité pour la dalle lumineuse.

Selon un mode de réalisation, la fabrication des circuits de commande dans le second substrat est réalisée selon une technique de fabrication de circuit ASIC, cette technologie permet un haut rendement, une forte densité de composants par unité de surface, tout en offrant une grande liberté dans la conception du schéma électronique de commande des micro-LEDs (nombre de transistors, condensateurs, connections électriques, etc.). Par ailleurs, cette technologie ne nécessite pas d'investissement aussi lourd que celui engagé pour s'équiper en machines capables de fabriquer des matrices actives TFT de grande taille.

Selon un mode de réalisation, le quatrième substrat ne comporte que des connexions électriques. Ainsi, le seul élément de la dalle lumineuse qui est possiblement fabriqué en un seul tenant (une seule pièce) ne comporte aucun élément actif (transistors par exemple). Ainsi, même si sa surface est importante, son coût est limité.

Selon un mode de réalisation, l'empilement constitutif des micro-LEDs du premier substrat est constitué de semi-conducteur III-V, en particulier à base de galium, notamment de nitrure de gallium (GaN), et/ou de phosphure de gallium (GaP) et/ou de nitrure de gallium-indium (InGaN), et/ou de nitrure d'aluminium-gallium (AlGaN), et/ou d'arséniure de gallium-indium (AlGaAs), et/ou de phosphoro-arséniure de gallium (GaAsP). Ce type de matériau semi-conducteur permet la fabrication de micro-LEDS émettant dans le rouge (ex. : GaAsP ;InGaP), dans le bleu (ex. : InGaN avec entre 10% et 20% d'In), et dans le vert (ex. : InGaN avec plus de 20% d'In, GaP, AlGaP). Il est ainsi possible de réaliser des éléments lumineux émettant par eux-mêmes la longueur d'onde souhaitée pour la dalle lumineuse, et ainsi se passer de filtres colorés usuellement utilisés.

Notamment, pour la fabrication d'une dalle lumineuse pour l'affichage d'images, comprenant donc trois éléments lumineux par point d'image (un pour chaque couleur rouge, verte et bleue), le procédé permet de réaliser indépendamment trois matrices de micro-puces, à raison d'une par couleur, et de réaliser leur report ultérieur sur le quatrième substrat à l'emplacement voulu pour la dalle lumineuse. En variante, pour chaque substrat de croissance sur lequel des micro-LED d'une couleur donnée sont fabriquées, un substrat silicium avec l'électronique de commande est reporté, puis les micro-puces de couleurs différentes ainsi obtenues sont reportées de la manière décrite précédemment.

Le procédé selon l'invention a pour objet de fabriquer une dalle lumineuse comportant :
- un substrat comportant des connexions électriques ;
- une matrice de micro-puces solidarisées au substrat et connectées aux connexions électriques pour leur pilotage, chaque micro-puce comportant un empilement:
   ∘ d'un circuit de commande actif à base de transistors formés dans un volume de silicium, ledit circuit étant connecté aux connexions électriques du substrat ;
   ∘ et d'une micro-LEDs solidarisée sur le circuit de commande et connectée à ce dernier pour sa commande.

En d'autres termes, la dalle lumineuse fabriquée selon l'invention permet de faire des écrans plus lumineux, avec une émission lambertienne (et donc sans problème d'angle de vue), plus efficaces énergétiquement, et potentiellement sur des substrats transparents.

Selon un mode de réalisation, les micro-LEDs sont constituées de semi-conducteur III-V, en particulier à base de gallium, notamment de nitrure de gallium (GaN), et/ou de phosphure de gallium (GaP) et/ou de nitrure de gallium-indium (InGaN), et/ou de nitrure d'aluminium-gallium (AlGaN), et/ou d'arséniure de gallium-indium (InGaAs), et/ou d'arséniure de gallium-aluminium (AlGaAs) et/ou de phosphoro-arséniure de gallium (GaAsP) et ou phosphure d'Indium Aluminium Gallium InGaAlP.

### BREVE DESCRIPTION DES FIGURES

L'invention sera mieux comprise à la lecture de la description qui va suivre, donnée uniquement à titre d'exemple, et réalisée en relation avec les dessins annexés, dans lesquels des références identiques désignent des éléments identiques, et dans lesquels :
- la figure 1 est une vue schématique en perspective d'une dalle lumineuse selon l'invention ;
- la figure 2 est une vue schématique en coupe d'une micro-puce entrant dans la constitution de la dalle selon l'invention ;
- la figure 3 est un schéma électrique illustrant un micro-LED et son circuit de commande ;
- la figure 4 est un schéma électrique illustrant des connexions d'un substrat d'interconnexion selon l'invention ;
- les figures 5A-5J illustrent un premier mode de réalisation du procédé de fabrication d'une dalle lumineuse selon l'invention ; et
- les figures 6A-6I illustrent un second mode de réalisation du procédé de fabrication d'une dalle lumineuse selon l'invention

### DESCRIPTION DETAILLEE DE L'INVENTION

Dans ce qui suit, les termes « inférieur » et « supérieur » se rapportent à l'agencement relatif d'éléments illustrés sur les figures.

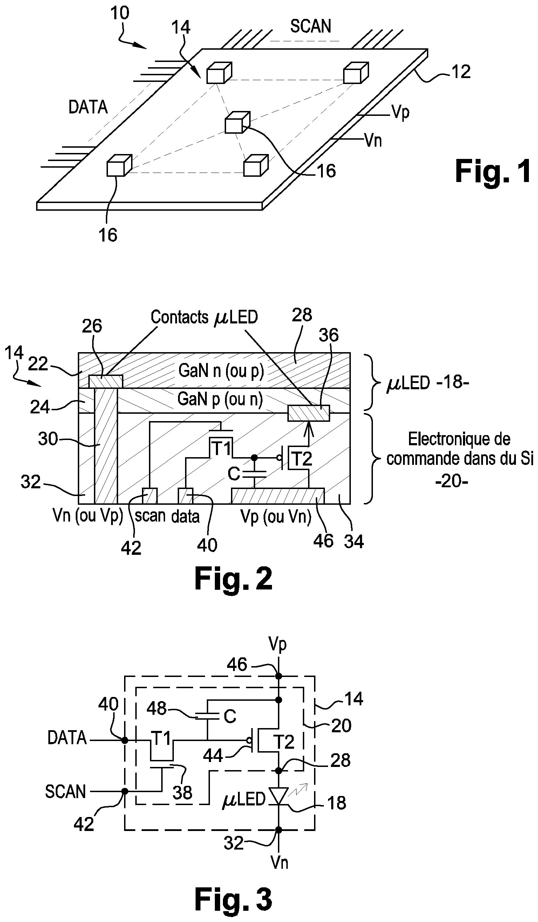

En se référant aux figures 1 à 3, une dalle lumineuse **10** selon un mode de réalisation de l'invention, par exemple pour un écran d'affichage (d'ordinateurs, de smartphones, de télévision, de tablettes,...) ou pour un projecteur d'images, comporte :
- un substrat de connexion électrique passif **12,** c'est-à-dire ne comportant que des conducteurs électriques, e.g. des pistes et des contacts électriques, pour l'amenée de signaux de commande de la dalle DATA et SCAN et pour l'amenée de tensions d'alimentation Vp et Vn ; et
- une matrice **14** de micro-puces électroluminescentes **16** solidaires du substrat passif **12** et connectées aux connecteurs électriques de ce dernier, les micro-puces étant spatialement agencées par exemple pour l'affichage d'images.

Chaque micro-puce **16** comporte, sur une portion supérieure, une micro-LED semi-conductrice et inorganique **18,** et sur une portion inférieure, solidaire de la portion supérieure, un circuit de commande actif **20** formé dans un bloc de silicium. Notamment, le circuit de commande n'est pas réalisé selon la technologie TFT.

Plus particulièrement, la micro-LED **18** comporte au moins une homojonction ou une hétérojonction, par exemple une jonction PN formée d'un empilement d'une couche semi-conductrice supérieure de type P (ou N) **22,** et d'une couche semi-conductrice inférieure de type N (resp. P) **24,** et deux contacts électriques **26, 28** pour injecter un courant électrique au travers de l'empilement, afin de produire de la lumière. Avantageusement, la micro-LED **18** est constituée de semi-conducteur III-V, en particulier à base de gallium, notamment de nitrure de gallium (GaN), et/ou de phosphure de gallium (GaP) et/ou de nitrure de gallium-indium (InGaN), et/ou de nitrure d'aluminium-gallium (AlGaN), et/ou d'arséniure de gallium-Aluminium (AlGaAs), d'arséniure de gallium-indium (InGaAs)et/ou de phosphoro-arséniure de gallium (GaAsP). Ce type de matériau semi-conducteur permet la fabrication de micro-LEDs émettant dans le rouge (ex. :AlGaAs, GaAsP, InGaAlP), dans le bleu (ex. : InGaN), et dans le vert (ex. : GaN, GaP,AlGaP). Bien entendu, la structure de la micro-LED **18** ne se réduit pas à l'empilement de deux couches N et P, par exemple en GaN, et peut prendre toute forme connue, par exemple une architecture « *planar* », une architecture de type *« MESA* », une architecture à base de nanofils, telle que décrite dans le document WO 2012/035243 et/ou WO 2012/156620, etc...

Une reprise de contact **30** est par ailleurs prévue au travers de la micro-puce **14** afin de connecter électriquement l'un des contacts électriques **26** de la micro-LED **18** avec un contact électrique **32** disposé sur la face inférieure **34** du circuit de commande **20.** La reprise de contact **30** est par exemple du type « *TSV»* (pour l'acronyme anglo-saxon « *trough-silicon via* »), et comporte à cet effet un trou traversant la micro-puce depuis le contact **26** jusqu'à la face **34,** trou dont la paroi est revêtue d'une couche d'isolant électrique, par exemple une couche de diélectrique, et qui est rempli d'un matériau conducteur d'électricité, par exemple un métal. L'autre contact **28** de la micro-LED **18** est par exemple disposé sur la face inférieure **36** de la micro-LED **18,** à l'interface avec la face supérieure du circuit de commande **20.**

Le circuit de commande **20** comporte quant à lui des composants électroniques (transistor(s), condensateur(s), résistances, etc.) pour la commande individuelle de la micro-LED **18** en fonction des signaux de commande DATA et SCAN. Cette commande individuelle permet un adressage actif de chaque micro-LED. Par exemple, en se référant à la figure 3, le circuit de commande **20** comporte :
- un premier transistor PMOS **38,** dont le drain est connecté à un contact de sortie **40** de la micro-puce **14** pour recevoir un signal DATA réglant l'état de la micro-LED **18** (allumée ou éteinte par exemple), et dont la grille est connectée à un contact de sortie **42** de la micro-puce **14** pour recevoir un signal SCAN autorisant ou non la mise à jour de l'état de la micro-LED **18** ;
- un second transistor NMOS **44**, dont la grille est connectée à la source du premier transistor PMOS **38**, dont le drain est connecté à un contact de sortie **46** de la micro-puce LED pour l'application d'une seconde tension d'alimentation Vp, et dont la source est connectée au contact **28** de la micro-LED **18.** Le second transistor **44** autorise ainsi la connexion de la micro-LED **18** et l'application de la différence de tension Vp-Vn entre les contacts **32** et **28**, et donc l'injection de courant dans la micro-LED **18** ; et
- un condensateur **48** connecté entre la grille et le drain du second transistor **44**, afin de maintenir l'état de la micro-LED **18** entre deux rafraichissements.

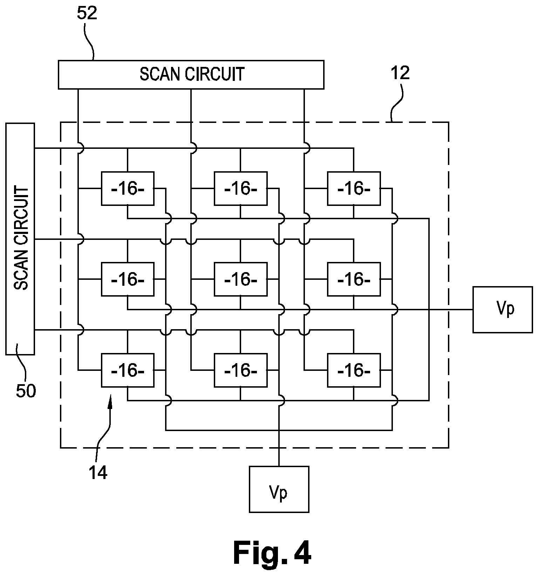

La figure 4 illustre un schéma de connexion et de commande de la dalle ainsi décrite, ici une dalle comprenant une matrice **14** de 3 lignes par 3 colonnes de micro-puces **16**, le substrat de connexion **12** étant connecté à un circuit **50** de rafraîchissement ligne par ligne de la matrice **14,** un circuit **52** contrôlant l'état d'éclairage des micro-LEDs de la ligne sélectionnée par le circuit **50**, et des sources de tension Vp et Vn.

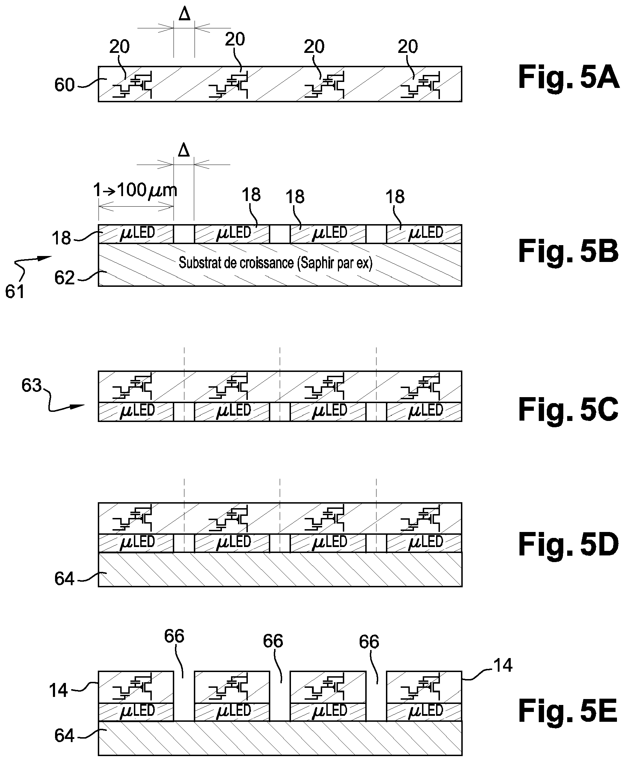

Il va à présent être décrit en relation avec les figures 5A - 5I un premier mode de réalisation d'un procédé de fabrication d'une dalle lumineuse selon l'invention, par exemple une dalle telle que décrite ci-dessus.

Le procédé débute par la fabrication d'une matrice de circuits de commande actifs **20** dans un substrat de silicium **60**, par exemple selon une technologie de fabrication de circuits ASIC (acronyme anglo-saxon de « *application-specific integrated circuit* »), bien connue en soi de l'état de la technique (figure 5A).

Les circuits **20** sont espacés d'au moins une distance Δ choisie pour réaliser une tranchée autour de chaque circuit **20** afin de pouvoir ultérieurement les individualiser. La distance Δ est par exemple choisie en fonction de la précision du processus de formation des tranchées, ce qui permet donc une densité maximale de circuits **20** compte tenue dudit processus.

Indépendamment de la fabrication de la matrice de circuits de commande **20**, le procédé comporte la fabrication d'un second substrat **61** comportant un empilement de couches semi-conductrices et de contacts électriques constitutifs de la matrice de micro-LEDs **18**. La fabrication de l'empilement de couches semi-conductrices constitutives des micro-LEDs, par exemple deux couches de GaN respectivement de type P et N, est par exemple réalisée par épitaxie sur un substrat de croissance **62** (e.g. en saphir ou en silicium), comme cela est bien connu de l'état de la technique (figure 5B). Par exemple, les micro-LEDs **18** sont fabriquées selon une technique décrite dans le document Journal of Crystal Growth 268 (2004) 527-530.

En se référant à la figure 5C, la matrice de circuit de commande **20** et la matrice de micro-LEDs **18** sont ensuite reportées l'une sur l'autre, et solidarisées l'une à l'autre, par exemple au moyen d'un collage direct hétérogène ou par une hybridation de type « flip-chip » utilisant des billes de soudure (ou « *bumps* »), et une thermocompression et/ou utilisant des micro-tubes creux, tels que décrits dans le document WO 2013/001225 ou dans le document FR 2 928 033. L'interconnexion des matrices est réalisée de manière à connecter le contact **28** de chaque micro-LEDs avec la borne correspondante du transistor **44** du circuit de commande associé. Les reprises de contact **30** de type TSV sont ensuite formées pour reprendre chaque contact **26** des micro-LEDS sur la face libre des circuits de commande. Le substrat de croissance **62** est ensuite retiré, par exemple par lift-off laser dans le cas d'un substrat en saphir, ou par polissage mécanique et gravure chimique au KOH dans le cas d'un substrat en Si.

Le troisième substrat **63**, ainsi formé de l'empilement des matrices de micro-LEDs et de circuits de commande, est ensuite reporté sur un substrat dit « poignée » **64**, par exemple en Si, au moyen d'un collage dit « temporaire », permettant un retrait ultérieur aisé, par exemple au moyen d'une résine, notamment un résine de référence « WaferBOND® HT-10.10 » de chez Brewer (figure 5D).

Le procédé se poursuit par l'individualisation de chaque micro-puce **14** en gravant autour de chacune d'elle une tranchée **66** jusqu'au substrat poignée **64**, par exemple une gravure RIE (« *Reactive Ion Etching* ») ICP (« *Inductive coupled plasma »* : mode de la RIE qui permet d'avoir une gravure plus directive) avec Cl₂ (figure 5E).

De manière indépendante aux étapes précédemment décrites, le procédé comprend la fabrication d'un quatrième substrat passif **68** ayant les dimensions souhaitées pour la dalle, et comprenant un réseau de connexions électriques pour la connexion électrique des contacts **32**, **40**, **42** et **46** prévus sur la face inférieures **34** de chaque circuit de commande **20**, par exemple une plaque de verre sur une face de laquelle sont formées des pistes électriques constituées d'oxyde d'indium-étain (ou « *ITO* »)*.*

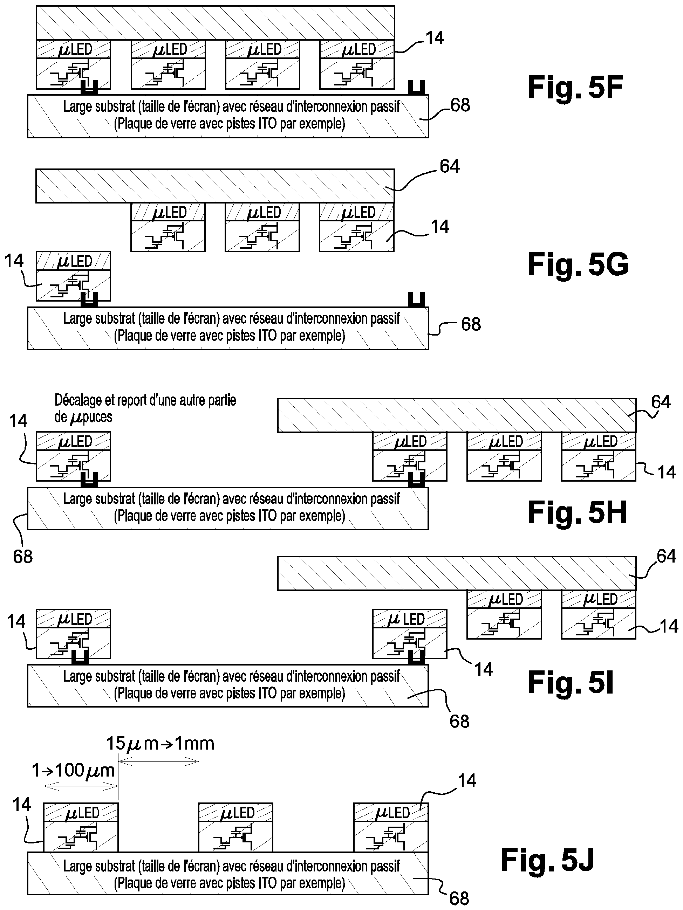

Les micro-puces **14,** attachées au substrat poignée **64** par leurs micro-LEDs **18**, sont ensuite reportées sur le substrat **68**, et solidarisées de manière à connecter électriquement les connexions électriques des circuits de commande aux connexions électriques correspondantes du substrat **68**, par exemple au moyen d'un collage direct hétérogène, ou d'une hybridation flip-chip telle que décrite précédemment (figure 5F). Les micro-puces **14** sont alors désolidarisées du substrat poignée **64** en chauffant par exemple à 300°C.

Dans la mesure où le pas des micro-puces **14** sur le substrat poignée **64** (de l'ordre de la dizaine de micromètres avec les techniques actuelles de fabrication, par exemple 30µm) peut être supérieur au pas de la matrice de micro-puces de la dalle lumineuse (actuellement de l'ordre de la centaine de micromètres, par exemple compris entre 15 micromètres et 1 millimètre), le procédé consiste par exemple à reporter une partie des micro-puces sur le substrat passif **68** (figure 5G), puis à décaler le substrat poignée avec les micro-puces restantes du pas de la dalle lumineuse, à reporter une autre partie des micro-puces (figures 5H, 5I), et ainsi de suite, jusqu'à complétion de la dalle lumineuse (figure 5J).

Dans ce premier mode de réalisation, il est employé un substrat poignée pour le report des micro-puces **14** sur le substrat de connexion passif **68**. L'emploi d'un substrat poignée **64**, adhérant aux micro-puces **14** par un collage temporaire, a pour avantage de pouvoir retirer le substrat de croissance quel qu'il soit. En revanche, il suppose une étape de fabrication et une étape de report supplémentaire.

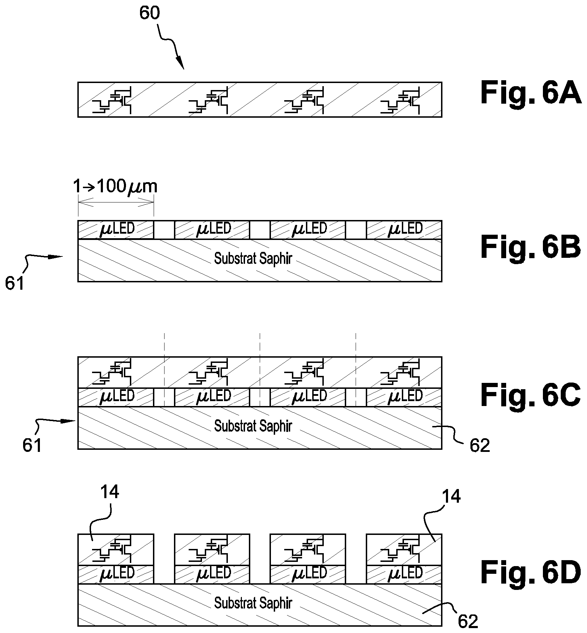

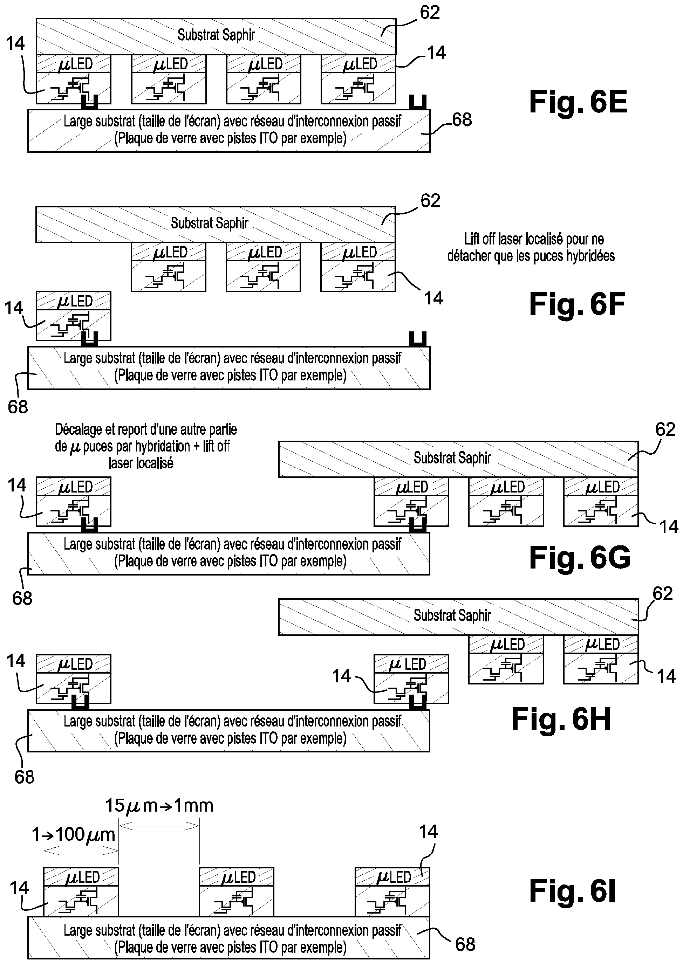

Selon un second mode de réalisation du procédé selon l'invention, illustré aux figures 6A-6I, le substrat de croissance **62** n'est pas éliminé une fois les premier et second substrats **60**, **61**, interconnectés l'un à l'autre, comme dans la Figure 5C, mais est utilisé en tant que substrat poignée, ce qui permet d'économiser une étape de fabrication et de report, et de faciliter l'alignement des micropuces **14** sur la matrice 68. Les micro-puces **14** sont alors détachées du substrat de croissance **62** par l'emploi d'un lift-off laser localisé, Figure 6F, tel que par exemple décrit dans le brevet américain US 6071795 (i.e. utilisation d'un laser pulsé KrF à 248 nm et exposition des µLEDs avec des énergies entre 100 et 600 mJ/cm²). Pour des µLEDs, une lentille peut permettre de focaliser le faisceau laser à l'interface entre le saphir et le GaN.

Pour les modes de réalisation du procédé de fabrication décrits ci-dessus, appliqués à la fabrication d'une dalle lumineuse pour l'affichage d'images en couleur, on peut commencer par procéder au report de micro-puces correspondant aux pixels bleus, en positionnant les interconnexions où il convient pour les pixels bleus, puis rajouter des interconnexions pour reporter les pixels verts, puis rajouter des interconnexions pour reporter les pixels rouge.

Par ailleurs, les interconnexions entre les micro-puces **14** et le substrat d'interconnexion **68** peuvent être des micro-tubes ou micro-piliers en cuivre (technologie dite « *micro-bumps* ») ou des pads de connexion en cuivre pour réaliser le collage direct entre pads (e.g. hétérogène ou par thermocompression).

Il a été décrit un circuit de commande particulier, induisant notamment quatre connexions électriques par micro-puce. Bien entendu, tout type de circuit de commande actif est envisageable. On peut notamment prévoir un dernier niveau d'interconnexion dans le procédé de fabrication de l'ASIC de manière à avoir une surface plane. Notamment, après les procédés de fabrication des transistors dans le silicium, la surface résultante peut ne pas être plane. Pour que l'interconnexion entre la matrice active en silicium et la matrice de micro-LED (e.g. en GaN) soit facilitée, il est préférable que les surfaces reportées l'une sur l'autre soient planes. A cet effet, un dernier niveau sur la matrice active est réalisé, en déposant un isolant diélectrique (e.g. du SiO₂), en le gravant, en faisant déboucher les gravures au niveau des connexions, en déposant du Cu pour remplir les trous de gravure et en finalisant par un procédé CMP (« *chemical mecanical polishing* ») pour avoir une surface plane. Ce type de technologie est usuellement connu sous le nom de « damascène ».

## Revendications

1. Procédé de fabrication d'une dalle lumineuse (10), comprenant :
- la fabrication d'un premier substrat (61) comportant :
∘ un empilement de couches semi-conductrices constitutives de micro-LEDs semi-conductrices inorganiques (18) ; et
∘ une matrice de connexions électriques (26, 28) pour les micro-LEDs,
la fabrication du premier substrat étant réalisée de telle sorte que les connexions électriques (26, 28) sont disposées sur une première face (36) du premier substrat;
- la fabrication dans un second substrat en silicium (60), indépendamment du premier substrat (61), d'une matrice de circuits de commande (20) des micro-LEDs (18) à base de transistor, ladite fabrication étant réalisée de telle sorte que :
∘ des premières connexions (28) pour la commande des micro-LEDs sont disposées sur une première face (34) du second substrat ;
∘ et des secondes connexions (32, 42, 46) pour le pilotage de la dalle lumineuse sont disposées sur une seconde face du second substrat;
- le report des premières faces du premier substrat (61) et du second substrat (62) l'une sur l'autre et la solidarisation desdites faces l'une à l'autre, de sorte à connecter électriquement les connexions électriques des micro-LEDs avec les premières connexions électriques des circuits de commande, obtenant ainsi un troisième substrat comprenant une matrice de micro-puces électroniques (16) constituée chacune de l'empilement d'une micro-LED (18) et d'un circuit de commande (20) ;
- la fabrication d'une structure de transfert (16, 64) des micro-puces comprenant :
∘ un substrat de transfert (64);
∘ et la matrice de micro-puces (16), chaque micro-puce étant solidarisée au substrat de transfert uniquement par sa micro-LED, et individualisée par la réalisation d'une tranchée (66) dans le troisième substrat autour de la micro-puce ;
- la fabrication d'un quatrième substrat (68), indépendamment de la structure de transfert, comportant des connexions électriques d'amenée de signaux pour le pilotage de la dalle lumineuse, lesdites connexions étant disposées sur une première face du quatrième substrat ;
- le report de la structure de transfert sur la première face du quatrième substrat, la solidarisation des micro-puces avec la première face du quatrième substrat de sorte à connecter les secondes connexions des circuits de commande avec les connexions électriques du quatrième substrat, et la désolidarisation des micro-puces du substrat de transfert.

2. Procédé de fabrication d'une dalle lumineuse selon la revendication 1, dans lequel la fabrication de la structure de transfert (16, 64) des micro-puces comporte :
- le report et le collage temporaire du troisième substrat sur le substrat de transfert (64) ;
- le suivi de la formation des tranchées (66) autours des micro-puces jusqu'au substrat de transfert.

3. Procédé de fabrication d'une dalle lumineuse selon la revendication 1, dans lequel :
- la fabrication du premier substrat comporte la fabrication d'un substrat de croissance (62) et la croissance par épitaxie de couches semi-conductrices constitutives des micro-LEDs (18), le substrat de croissance formant le substrat de la structure de transfert des micro-puces ;
- la fabrication de la structure de transfert des micro-puces comporte la formation de tranchée (66) autour des micro-puces aboutissant jusqu'au substrat de transfert ;
- la désolidarisation des micro-puces du substrat de transfert comporte l'irradiation laser du substrat de transfert au droit des micro-puces de manière à obtenir le détachement de celles-ci du substrat de transfert.

4. Procédé de fabrication d'une dalle lumineuse selon la revendication 1, 2 ou 3, dans lequel :
- la matrice de micro-puces (16) de la structure de transfert présente un premier pas de répétition ;
- les connexions électriques du quatrième substrat (68) sont agencées en matrice avec un second pas de répétition supérieur au premier pas de répétition ;
- le report de la structure de transfert (16, 64), la solidarisation des micro-puces avec la première face du quatrième substrat (68), et la désolidarisation des micro-puces (16) du substrat de transfert, comprennent :
∘ le report de la structure de transfert à une première position du quatrième substrat;
∘ la solidarisation d'au moins une première micro-puce à la première position ;
∘ le report de la structure de transfert à une seconde position du quatrième substrat en décalant la structure de transfert et le quatrième substrat l'un par rapport à l'autre du second pas de répétition ;
∘ et la solidarisation d'au moins une seconde micro-puce à la seconde position.

5. Procédé de fabrication d'une dalle lumineuse selon l'une des revendications précédentes, dans lequel la fabrication des circuits de commande (20) dans le second substrat est réalisée selon une technique de fabrication de circuit ASIC.

6. Procédé de fabrication d'une dalle lumineuse selon l'une des revendications précédentes, dans lequel le quatrième substrat (68) ne comporte que des connexions électriques.

7. Procédé de fabrication d'une dalle lumineuse selon l'une quelconque des revendications précédentes, dans lequel l'empilement constitutif des micro-LEDs (18) du premier substrat est constitué de nitrure de gallium, et/ou de nitrure de gallium-indium, et/ou de nitrure d'aluminium-gallium.

## Patentansprüche

1. Verfahren zur Herstellung einer beleuchteten Frontplatte (10), umfassend:
- die Herstellung eines ersten Substrats (61), das enthält:
∘ einen Stapel Halbleiterschichten, bestehend aus anorganischen, halbleitenden Mikro-LED (18); und
∘ eine Matrix von elektrischen Anschlüssen (26, 28) für die Mikro-LED,
wobei die Herstellung des ersten Substrats dabei in einer Art und Weise erfolgt, dass die elektrischen Anschlüsse (26, 28) auf einer ersten Seite (36) des ersten Substrats angeordnet sind;
- die Herstellung in einem zweiten Substrat aus Silizium (60), das vom ersten Substrat (61) unabhängig ist, einer Matrix Steuerschaltungen (20) der Mikro-LED (18) auf Transistorbasis, wobei diese Herstellung dabei in einer Art und Weise erfolgt, dass:
∘ erste Anschlüsse (28) zur Steuerung von Mikro-LED auf einer ersten Seite (34) des zweiten Substrats verteilt sind;
∘ und zweite Anschlüsse (32, 42, 46) zur Steuerung der beleuchteten Frontplatte auf einer zweiten Seite des zweiten Substrats verteilt sind;
- den Übertrag der ersten Seiten des ersten Substrats (61) und des zweiten Substrats (62) übereinander sowie die Befestigung dieser Seiten aneinander, so dass die elektrischen Anschlüsse der Mikro-LED (18) elektrisch verbunden werden mit den ersten elektrischen Anschlüssen der Steuerschaltungen, wodurch sich ein drittes Substrat ergibt, das eine Matrix aus elektronischen Mikrochips (16) enthält, von denen jeder aus einem Stapel aus einer Mikro-LED (18) und einer Steuerschaltung (20) besteht;
- die Herstellung einer Transferstruktur (16, 64) der Mikrochips, umfassend:
∘ ein Transfersubstrat (64);
∘ und die Matrix der Mikrochips (16), wobei jeder Mikrochip am Transfersubstrat nur über seine Mikro-LED befestigt ist und durch Ausführung eines Einschnitts (66) im dritten Substrat um den Mikrochip herum individualisiert wird;
- die Herstellung eines vierten Substrats (68), unabhängig von der Transferstruktur, das elektrische Anschlüsse für den Eingang von Signalen zur Steuerung der beleuchteten Frontplatte enthält, wobei diese Anschlüsse auf einer ersten Seite des vierten Substrats angeordnet sind;
- den Übertrag der Transferstruktur auf die erste Seite des vierten Substrats, die Befestigung der Mikrochips an der ersten Seite des vierten Substrats, so dass die zweiten Verbindungen der Steuerschaltungen mit den elektrischen Anschlüssen des vierten Substrats verbunden werden, sowie das Lösen der Mikrochips vom Transfersubstrat.

2. Verfahren zur Herstellung einer beleuchteten Frontplatte nach Anspruch 1, bei dem die Herstellung der Transferstruktur (16, 64) der Mikrochips umfasst:
- Übertrag und vorübergehendes Kleben des dritten Substrats auf das Transfersubstrat (64);
- Verfolgung der Bildung der Einschnitte (66) um die Mikrochips herum bis zum Transfersubstrat.

3. Verfahren zur Herstellung einer beleuchteten Frontplatte nach Anspruch 1, bei dem
- die Herstellung des ersten Substrats die Herstellung eines Wachstumssubstrats (62) und das Wachstum durch Epitaxie der Halbleiter-Schichten, die die Mikro-LED (18) bilden, beinhaltet, wobei das Wachstumssubstrat dabei das Substrat der Transferstruktur der Mikrochips bildet;
- die Herstellung der Transferstruktur der Mikrochips die Bildung von Einschnitten (66) um die Mikrochips herum beinhaltet, die bis zum Transfersubstrat führen;
- das Lösen der Mikrochips vom Transfersubstrat eine Laser-Bestrahlung des Transfersubstrats an den Mikrochips beinhaltet, um so zu erreichen, dass diese sich vom Transfersubstrat lösen.

4. Verfahren zur Herstellung einer beleuchteten Frontplatte nach Anspruch 1, 2 oder 3, bei dem
- die Mikrochip-Matrix (16) der Transferstruktur einen ersten Wiederholungsschritt aufweist;
- die elektrischen Anschlüsse des vierten Substrats (68) in der Matrix in einem zweiten Wiederholungsschritt oberhalb des ersten Wiederholungsschritts angeordnet werden;
- der Übertrag der Transferstruktur (16, 64), die Befestigung der Mikrochips an der ersten Seite des vierten Substrats (68) und das Lösen der Mikrochips (16) vom Transfersubstrat umfassen:
∘ den Übertrag der Transferstruktur an eine erste Position des vierten Substrats;
∘ die Befestigung mindestens eines ersten Mikrochips an der ersten Position;
∘ den Übertrag der Transferstruktur an eine zweite Position des vierten Substrats, wobei die Transferstruktur und das vierte Substrat zueinander bezogen auf den zweiten Wiederholungsschritt versetzt sind;
∘ und die Befestigung mindestens eines zweiten Mikrochips an der zweiten Position.

5. Verfahren zur Herstellung einer beleuchteten Frontplatte nach einem der vorhergehenden Ansprüche, bei dem die Herstellung der Steuerschaltungen (20) im zweiten Substrat entsprechend einer Fertigungstechnik für ASIC-Schaltkreise ausgeführt wird.

6. Verfahren zur Herstellung einer beleuchteten Frontplatte nach einem der vorhergehenden Ansprüche, bei dem das vierte Substrat (68) keine elektrischen Anschlüsse enthält.

7. Verfahren zur Herstellung einer beleuchteten Frontplatte nach einem der vorhergehenden Ansprüche, bei dem der Stapel, aus dem die Mikro-LED (18) des ersten Substrats bestehen, aus Galliumnitrid, und/oder Gallium-Indium-Nitrid, und/oder Aluminium-Gallium-Nitrid bestehen.

## Claims

1. A method of manufacturing a luminous panel (10) comprising:
- manufacturing a first substrate (61) comprising:
∘ a stack of semiconductor layers forming inorganic semiconductor micro-LEDs (18); and
∘ an array of electric connections (26, 28) for the micro-LEDs,
the manufacturing of the first substrate being carried out in such a way that the electric connections (26, 28) are arranged on a first surface (36) of the first substrate;
- manufacturing in a second silicon substrate (60), independently from the first substrate (61), an array of circuits (20) for controlling the micro-LEDs (18) based on transistors, said manufacturing being carried out so that:
∘ first connections (28) for the control of the micro-LEDs are arranged on a first surface (34) of the second substrate;
∘ and second connections (32, 42, 46) for the driving of the luminous panel are arranged on a second surface of the second substrate;
- placing the first surfaces of the first substrate (61) and of the second substrate (62) one on the other and securing said surfaces to each other, to electrically connect the electric connections of the micro-LEDs with the first electric connections of the control circuits, thus obtaining a third substrate comprising an array of electronic microchips (16), each formed of the stacking of a micro-LED (18) and of a control circuit (20);
- manufacturing a microchip transfer structure (16, 64) comprising:
∘ a transfer substrate (64);
∘ and the array of microchips (16), each microchip being secured to the transfer substrate only by its micro-LED, and individualized by the forming of a trench (66) into the third substrate around the microchip;
- manufacturing a fourth substrate (68), independently from the transfer structure, comprising electric connections for supplying signals for driving the luminous panel, said connections being arranged on a first surface of the fourth substrate;
- placing the transfer structure on the first surface of the fourth substrate, securing the microchips to the first surface of the fourth substrate to connect the second connections of the control circuits with the electric connections of the fourth substrate, and separating the microchips from the transfer substrate.

2. The luminous panel manufacturing method of claim 1, wherein the manufacturing of the microchip transfer structure (16, 64) comprises:
- placing and temporarily bonding the third substrate to the transfer substrate (64);
- then, forming the trenches (66) around the microchips down to the transfer substrate.

3. The luminous panel manufacturing method of claim 1, wherein:
- the manufacturing of the first substrate comprises manufacturing a growth substrate (62) and growing by epitaxy semiconductor layers forming the micro-LEDs (18), the growth substrate forming the substrate of the microchip transfer structure;
- the manufacturing of the microchip transfer structure comprises forming trenches (66) around the microchips down to the transfer substrate;
- the separation of the microchips from the transfer substrate comprises a laser irradiation of the transfer substrate on the microchips, perpendicularly thereto, to obtain a separation thereof from the transfer substrate.

4. The luminous panel manufacturing method of claim 1, 2, or 3, wherein:
- the array of microchips (16) of the transfer structure exhibits a first repetition pitch;
- the electric connections of the fourth substrate (68) are arranged in an array with a second repetition pitch larger than the first repetition pitch;
- the transfer of the transfer structure (16, 64), the securing of the microchips to the first surface of the fourth substrate (68), and the separation of the microchips (16) from the transfer substrate, comprise:
∘ placing the transfer structure in a first position of the fourth substrate;
∘ securing at least one first microchip at the first position;
∘ placing the transfer structure in a second position of the fourth substrate by shifting the transfer structure and the fourth substrate with respect to each other by the second repetition pitch;
∘ and securing at least one second microchip at the second position.

5. The luminous panel manufacturing method of any of the foregoing claims, wherein the control circuits (20) in the second substrate are manufactured according to an ASIC manufacturing technique.

6. The luminous panel manufacturing method of any of the foregoing claims, wherein the fourth substrate (68) only comprises electric connections.

7. The luminous panel manufacturing method of any of the foregoing claims, wherein the stack forming the micro-LEDs (18) of the first substrate is made of gallium nitride, and/or of indium gallium nitride, and/or of aluminum gallium nitride.
